Europäisches Patentamt

European Patent Office

Office européen des brevets

(19)

(11) Publication number: **0 237 406**
**A2**

# (12) EUROPEAN PATENT APPLICATION

(21) Application number: **87400433.6**

(22) Date of filing: **27.02.87**

(51) Int. Cl.⁴: **G 01 R 31/28**

(30) Priority: **27.02.86 US 834298**

(43) Date of publication of application:
**16.09.87 Bulletin 87/38**

(84) Designated Contracting States: **DE FR GB IT NL**

(71) Applicant: **FAIRCHILD SEMICONDUCTOR CORPORATION**
**10400 Ridgeview Court P.O. Box 1500**
**Cupertino California 95014 (US)**

(72) Inventor: **Richardson, Neil**
**509 Sierra Vista, No. 3,**
**Mountain View California 94043 (US)**

(74) Representative: **Monod, Jean-Yves et al**
**SCHLUMBERGER LIMITED 12 Place des Etats-Unis**
**F-92124 Montrouge Cedex (FR)**

(54) Electron beam testing of semiconductor wafers.

(57) A method for testing a semiconductor structure during and after fabrication includes the steps of fabricating test patterns thereon which test patterns include regions of conductive material connected to the substrate as well as regions of conductive material isolated from the substrate; grounding the substrate; directing a beam of electrons onto the test pattern, which beam has an energy sufficient to cause the secondary emission coefficient of the conductive material to exceed unity and thereby produce a voltage contrast between those regions of conductive material connected to the substrate and those isolated from the substrate; and detecting the resulting voltage contrast between the portions of conductive material grounded and those not grounded to thereby determine the propriety of the fabrication process.

$$E_I < E_L < E_2$$

**Description**

ELECTRON BEAM TESTING OF SEMICONDUCTOR WAFERS

BACKGROUND OF THE INVENTION

Field of the Invention

This invention relates to the testing of integrated circuits, and in particular, to the testing of integrated circuits at various stages of their fabrication, without physically contacting them, to assure that the process steps employed in fabrication and the resulting semiconductor structures are as intended.

Description of the Prior Art

In the fabrication of integrated circuits, a semiconductor wafer, typically silicon, is subjected to a large number of process operations by which doped regions of P and N conductivity type and varying concentrations are formed in the wafer, together with layers of insulating and electrically conductive material deposited on the surface of the wafer. Because the cost of passing a wafer through an integrated circuit fabrication process is substantially independent of the number of circuits fabricated therein, it is desirable to maximise the density of the electronic components formed in and on the wafer by minimizing the dimensions of the features of the electronic devices being fabricated. With state-of-the-art fabrication technology, features on the order of 1 micron are readily available, and advances in fabrication technology make likely the existence of substantially smaller features. To maximise the yield of finished integrated circuits from a wafer, it is desirable to monitor the processing of that wafer through the fabrication operations with extreme care. In this manner a fabrication operation incompletely or improperly performed may be corrected, or the wafer discarded, before additional resources are expended in subsequent process operations.

Because of the extremely small feature size available in the semiconductor fabrication technology, physically contacting the wafer with probes to measure the characteristics of the features thus far formed at any given stage in the process is undesirable. The finest features obviously would be destroyed by any physical contact, yet bonding pads or other large regions on the wafer surface to which contact might otherwise be desirable may have yet to be fabricated at the time the in-process test is desired. Accordingly, a need exists to measure the electrical parameters of structures formed on and in the wafers during the fabrication processes so that more effective control of the processing steps may be achieved. Defects found during the process may be remedied by corrective action, instead of numerous faulty wafers being processed until a final test reveals a problem.

At present there are two commonly-used methods of process control employed for in-process wafers. These methods are optical inspection and parametric testing. Optical inspection, for example, under high-powered microscopes, permits verification of mask alignment, measurement of critical dimensions, and occasionally identification of random defects. Although optical inspection has been automated to some extent, because it only deduces electrical performance indirectly, fatal flaws will often escape notice.

Parametric testing, for example as performed by Keithley Instruments testers, produces detailed statistics of many process variables, but is typically only applicable for completed or nearly completed wafers because bonding pads are required to make electrical connections to the tester. Thus, parametric testing is applicable almost exclusively only to post-process testing of semiconductor wafers and to testing where the wafer may be physically contacted.

Furthermore, the enormous number of features on a single wafer makes actual verification of each feature essentially impossible. A single integrated circuit on one wafer may contain a half million transistors, each one of which includes many features, without regard to the electrical interconnection of such a large number of devices. Thus, a need exists for a statistical approach to assure the quality of semiconductor wafer fabrication processes. Neither of the prior art approaches provide such.

SUMMARY OF THE INVENTION

It is a general object of the invention to provide a method of electron beam testing of semiconductor wafers and to provide a test pattern therefore.

This and other objects are attained, in accordance with one aspect of the invention by a method for testing a semiconductor structure having at least one test pattern including a first region of conductive material electrically coupled to the wafer substrate and a second region of conductive material electrically isolated from the substrate; connecting the substrate to a first potential source; directing a single beam of electrons onto the test pattern, the beam having an energy sufficient to cause the secondary emission coefficient of the conductive material to exceed unity and thereby provide a voltage contrast between the first and second conductive regions; and detecting the voltage contrast between the first and second conductive regions to thereby determine the propriety of the fabrication process.

Another aspect of the invention includes a test pattern for verifying a minimum distance in a semiconductor structure, the pattern for use in apparatus for measuring voltage contrast and having a first region of conductive material disposed over the semiconductor structure and coupled to the substrate and a second region of conductive material electrically isolated from the potential source and disposed the minimum distance from the first region.

## IN THE DRAWINGS

Figure 1 is a graph illustrating the relationship of secondary emission coefficient to beam landing energy;

Figure 2 is a schematic drawing of apparatus employed in carrying out the invention;

Figure 3 is a cross-section of a semiconductor structure illustrating voltage contrast;

Figure 4 is a cross-section of a semiconductor structure illustrating a typical test pattern;

Figure 5 is a top view of the structure shown in Figure 4;

Figure 6a is a top view of an array of test patterns; and

Figure 6b illustrates hypothetical output signals for the test pattern array of Figure 6a.

## DETAILED DESCRIPTION OF THE PREFERRRED EMBODIMENT

The phenomenon of voltage contrast in semiconductor structures under the influence of electron beams is known. See, for example, "Fundamentals of Electron Beam Testing of Integrated Circuits," by Menzel and Kubalek, Scanning, Vol. 5, No. 3 (1983). As generally described therein, an electron beam impinging upon an integrated circuit structure causes secondary emission of electrons from the conductive and insulating regions of the integrated circuit. The extent of the secondary emission is primarily dependent upon the energy of the impinging electron beam. Because the different materials will have different local potentials, different electric fields are created, which results in different voltage contrasts for differing regions. When viewed with an electron microscope, the parts of the device having a positive voltage appear dark, while parts having a negative voltage appear brighter. This phenomenon is discussed in greater detail in the above reference.

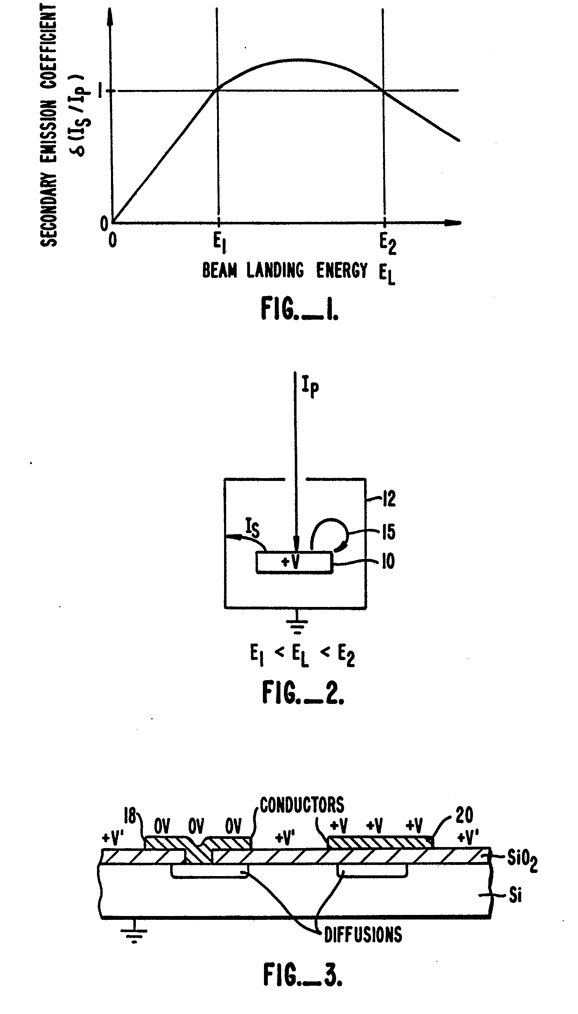

Figure 1 is a graph illustrating the relationship between beam landing energy and secondary emission coefficient $\delta$. As shown in Figure 1, the number of secondarily-emitted electrons increases as beam landing energy increases. Ultimately, as the landing energy increases a beam landing energy $E_1$ is reached at which more secondarily-emitted electrons occur than the number of electrons impinging upon the structure itself. At this energy, by definition, the secondary emission coefficient exceeds unity, that is, the ratio of secondarily-emitted electrons ($I_s$) divided by the primary electrons ($I_p$) is greater than one. As beam landing energy continues to increase, the secondary emission coefficient remains above one until the landing energy of $E_2$ is reached, at which energy the emission coefficient declines and remains below one for higher energies.

The behavior depicted in Figure 1 is typical for almost all materials used in the fabrication of integrated circuits. For example, for conductors such as aluminum and polycrystalline silicon, the secondary yield of electrons exceeds unity over a range between about 200 electron volts and 700 electron volts. For insulators, such as silicon dioxide, the range shifts to where the secondary emission coefficient exceeds one between about 400 electron volts and 900 electron volts. It is this secondary yield of electrons which creates the voltage contrast relied upon by my invention for the remote testing of integrated circuit process variables.

Figure 2 schematically illustrates apparatus with which my invention may be employed. A primary electron beam $I_p$ having a beam landing energy in the range where the secondary emission coefficient is greater than one is caused to impinge upon a floating conductor 10. The conductor is surrounded by a grounded enclosure 12. The primary electron beam causes secondary emissions $I_s$ which result in the conductor 10 becoming positively charged. In equilibrium a fraction of the secondary yield escapes to ground 12, while many of the lower energy electrons 15 are returned to the conductor 10. When the current escaping to ground equals the primary beam current, the secondary emission coefficient is one. The effect is a result of the nature of the secondary emission energy spectrum. (A typical secondary emission spectrum for aluminum is depicted in Figure 1 of the above reference.) The small positive potential builds up by the continued net loss of electrons until the retarding field causes the lower energy secondary electrons to return to the electrode from which they originated (or a nearby electrode) thereby reducing the net loss to zero.

Figure 3 is a cross-section of a partially-completed silicon wafer, and illustrates the manner by which the voltage contrast phenomenon may be employed to detect the condition of semiconductor structures in process. The structure of Figure 3 is a typical semiconductor which includes a silicon wafer having a overlying layer of silicon dioxide. One or more diffused regions have been formed in the wafer, and conductive materials deposited thereon. A conductor 18 is shown deposited in contact with one of the diffused regions, while conductor 20 is isolated from the substrate by the silicon dioxide layer.

When the structure in Figure 3 is scanned with an electron beam, for example having an energy of 600 electron volts, the silicon dioxide regions charge positively by a few volts $+V'$, while the floating conductor 20 charges positively by a similar amount $+V$. Conductor 18, which is connected to the substrate through an opening in the silicon dioxide layer, remains, however, at zero volts because of the leakage path to ground. Because this leakage path involves only a small fraction of a nanoamp, for example .2 nanoamps, the nature of the substrate and of the diffusion doping has essentially no influence on the current flow. Thus, the current flow will occur without regard to whether conductor 18 forms one electrode of the diode, part of a transistor, or otherwise involves a PN junction within the substrate. When the structure depicted in Figure 3 is viewed with a scanning electron microscope, the voltage contrast phenomenon is clear, with the positive features conductor 20 and silicon dioxide, appearing dark, and the grounded features, conductor 18, appearing bright.

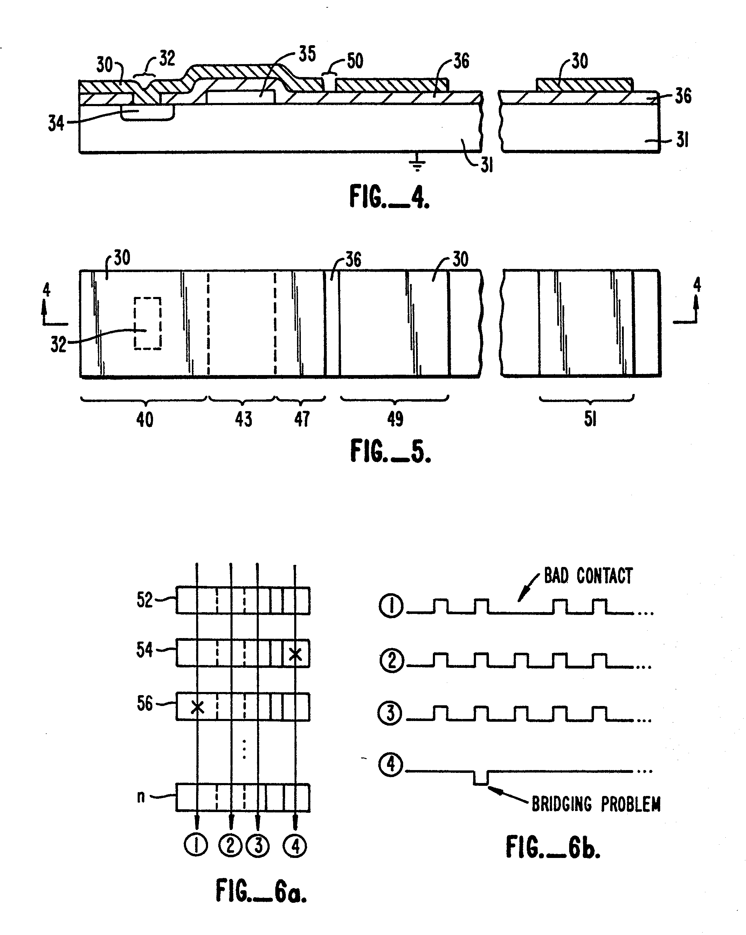

Figures 4 and 5 illustrate a test pattern which may be employed to verify the accuracy and/or functionality of various process steps employed in the fabrication of integrated circuits. At the left-hand side of each of Figures 4 and 5, a conductive layer 30 contacts a diffused region 34 through a via 32 in a layer of insulating material 36. The left-hand portion 40, depicted in Figures 4 and 5, permits testing of the integrity of contact formation. If, under an electron microscope the feature 40 appears bright, i.e., layer 30 is grounded, then the integrity of the via and of the conductor 30/diffusion 34 interface are verified. If it appears dark, i.e., layer 30 is "floating" then the problem exists with the via or contact interface. Test patterns such as depicted may be fabricated in otherwise unused surface area on the chip, e.g., between bonding pads, in spaces between conductors, by the copyright notice, etc.

Portions 43 and 47 of the structure of Figures 4 and 5 allow verification of metal bridging and step coverage. As shown from left to right in Figures 4 and 5, layer 30 traverses a step 35 in the underlying structure. It is well known in integrated circuit fabrication technology that traversing such steps may cause cracking in the overlying layers, and the middle portions of 43 and 47 of Figures 4 and 5 permit the use of voltage contrast to verify the quality of step coverage. Thus, if a crack occurs in layer 30 between regions 40 and 43, portions 43 and 47 of metal layer 30 will not be coupled to ground and will therefore be positively charged and appear dark instead of bright. Similarly, if a crack occurs at conductive layer 30 between regions 43 and 47, regions 40 and 43 will appear bright and region 47 dark, thereby disclosing the existence of the crack.

A minimum dimension gap 50 left in the test pattern conductive layer 30 allows verification that the integrity of the smallest feature, e.g., minimum line width, of the integrated circuit is being maintained. If this feature is properly maintained, region 49 of layer 30 will be electrically isolated from the substrate, and therefore charged to a positive potential to appear dark. If the integrity of minimum feature dimension 50 is not maintained, then region 49 will be shorted to region 47, discharged to ground, and appear bright.

The test pattern depicted in Figures 4 and 5 may be fabricated in the following manner. Over a semiconductor substrate 31 a region of material 35 is formed, which material may be electrically conductive, electrically insulating, or semiconductive. Such a region may be achieved by depositing a layer across the entire surface of the substrate and then photolithographically patterning that layer to define region 35. A layer of insulating material 36 is then formed across the upper surface of the substrate and region 35, for example, by thermal oxidation or vapor deposition. An opening 32 is formed in insulating material 36 and a suitable P or N conductivity type impurity region 34 formed in the substrate by thermal diffusion or other well known techniques. (Region 34 may also be formed as a preliminary step to the entire process, that is, by well known diffusion or implantation techniques prior to the fabrication of region 35.) Across the upper surface of insulating layer 36 a conductive layer 30 is deposited, for example, by sputtering aluminum or vapor deposition of polycrystalline silicon or other well known materials. Layer 30 may then be patterned using well known fabrication techniques, for example, photolithographically. In the course of such patterning a minimum dimension gap 50 is provided in layer 30. Other spaced-apart regions, such as region 51 depicted on the right-hand side of Figures 4 and 5, may be formed contemporaneously to allow testing for pin hole defects in insulating layer 36.

A further region 51 of metal 30 deposited on insulating layer 36 allows testing for the existence and/or quantity of pin hole defects in oxide 36. As discussed above, if the electrode is isolated it will appear dark. On the other hand, pin holes in the underlying oxide will cause leakage from the electrode causing it to appear bright. To obtain a greater sampling of the integrity of the oxide or other insulator, the electrode may be tested before patterning i.e., in circumstances when the entire substrate is coated with a single layer of metal isolated from the substrate such as in the capacitor of a dynamic random access memory cell.

The structure depicted in Figures 4 and 5 is simply for illustration. Numerous other such patterns will be readily apparent to those skilled in integrated circuit fabrication technology to allow verification of other aspects of semiconductor processing. For example, structures may be used to verify the integrity of contact cleanliness, undercut etching processes, lift-off masking, etc.

The technique depicted in Figures 4 and 5 is particularly advantageous as it may be performed without physically contacting the wafer with a probe or other device which might result in the destruction or modification of surface features of the wafer. Additionally the technique is nondestructive in that relatively low power electron beams may be employed which do not affect the structure. It is known, for example, that higher powered electron beams applied to MOS devices, may implant charge into the thin gate oxide and thereby alter the threshold voltage of the MOS device. A 600-electron volt beam will penetrate only about 300 Angstroms. Furthermore, the technique of my invention is particularly advantageous when employed with stepper technology where all die on a given wafer must be identical, and there is therefore no opportunity for the fabrication of special test die. Because bonding pads are not required to verify the electrical integrity of the circuit features, valuable surface area is not unnecessarily consumed. These bonding pads are required in conjunction with conventional testing of chips fabricated using stepper technology.

Table 1 below illustrates how process defects may be diagnosed using the test pattern shown in Figures 4 and 5.

4

0 237 406

## TABLE 1

| Test | | | | | Interpretation |
|---|---|---|---|---|---|
| 40 | 43 | 47 | 49 | 51 | |
| 0 | 0 | 0 | +V | +V | OK |
| 0 | 0 | 0 | 0 | +V | Metal bridging problem (47 shorted to 48) |
| 0 | +V | +V | +V | +V | Step coverage problem (crack between 40 and 43) |
| 0 | 0 | +V | +V | +V | Step coverage problem (crack between 43 and 47) |
| +V | +V | +V | +V | +V | Contact problem (40 not connected to substrate) |
| 0 | 0 | 0 | +V | 0 | Possible pin holes (51 shorted to substrate) |

(where 0 implies bright
and +V implies dark)

If the pattern has been correctly fabricated, then the electron beam will cause regions 40, 43 and 47 to appear bright and regions 49 and 51 dark. This is shown in the first row of the table. If there is a metal bridging problem such as a short across region 50, then all regions will appear bright. A step coverage problem will cause regions 43 and 47 or just region 47 to appear dark, depending upon where the break occurs. Pin hole defects in insulator 36 may short region 51 to the substrate. Finally, an improperly formed contact will cause all regions to be dark. The brightness or darkness of the various regions may be automatically detected using pattern recognition techniques.

The method and apparatus of my invention may also be employed to obtain measurements of the thickness of conductive material on semiconductor structures. This is achieved by measuring the time required to charge a known surface area to a particular level of blackness. Employing a low power electron beam can increase the sensitivity of the measurement.

Because of the compactness of the test pattern, a single test pattern may consume an area of the wafer only a few minimum line widths in one horizontal dimension, and several minimum line widths in an orthogonal direction, an array of such patterns may be fabricated on a single chip. Figures 6a and 6b illustrate how arrays of test patterns may be manufactured and scanned quickly to give an essentially digital output indicative of the condition of the wafer. The provision of arrays of such test patterns provides a larger statistical sample for the detection of defects. In this manner very low defect rates may be detected by the provision of large numbers of test patterns in what would otherwise be unused surface area of the chip. For example by providing 40 test patterns on each of the 40 chips on a single wafer, 1600 test patterns are provided, thereby allowing reliable detection of defects occurring only one every thousand times.

Depicted in Figure 6a is an array of n test patterns designated 52, 54, 56...n. Each test pattern comprises a pattern such as that depicted in the left-hand portion of each of Figures 4 and 5. Of course, if desired the pin hole test of the right-hand portion of Figures 4 and 5 could be added. By placing the test patterns in alignment in the manner shown in Figure 6a, they may be scanned to provide an essentially digital output relating to the defect densities on the wafer. Shown in Figure 6a are four scans of an electron beam, designated 1, 2, 3, and 4. For the sake of illustration, assume that no contact is made between metal 30 and diffusion 34 in test pattern 56. This location is shown by an X where scan 1 crosses test pattern 56. Also assume that an undesired metal bridge has been formed between regions 47 and 49 in test pattern 54. This location is also designated with an X.

Figure 6b illustrates the output signals resulting from scanning the array of Figure 6a with an electron beam. As shown in Figure 6b the third "bit" in scan 1 will be lost because of the bad contact in pattern 56. That is, as the beam follows scan path 1, alternating light and dark regions will be detected--the bright regions corresponding to the satisfactory contacts of patterns 52 and 54, and the dark regions corresponding to the insulating material between the patterns. Then when the region denoted with an X in pattern 56 is scanned, no bright region is detected, because of the bad contact, thereby indicating a defect.

5

Similarly, the results of scan 4 are uneventful as it will detect dark regions for each isolated conductor, as well as the intervening insulating material. When strip 54 is scanned, however, a bright region will be detected where the undesired metal bridge has been created, thereby also indicating a defect.

Because patterns such as depicted in Figure 6a are relatively large, that is on the order of a few microns square, it is not necessary to use a very small diameter electron beam, as might commonly be employed in scanning electron microscopes. Thus, a 600 electron volt beam, which is difficult to focus below 1 micron, may be readily employed. Additionally, the use of an array of devices facilitates employment of pattern recognition equipment in detecting and monitoring the test patterns, as well as eliminating the need for precise alignment of the chip to detect the test pattern.

The invention may be carried out using a standard scanning electron microscope operated at low voltage, for example, a Cambridge Instruments S-200 (Cambridge, England); a JEOL JSM 35C (Japan); or similar instrument such as those manufactured by Amray (Bedford, Mass.) or Hitachi (Japan).

Because most of these instruments will be operated at the low end of their operating voltage range, use of a special purpose instrument may be desirable. A specialized instrument will make the voltage contrast image more clear by eliminating tertiary electrons (from the vessel walls) or back scattered electrons from the image. One such special purpose instrument is described in my copending commonly assigned patent application: "Electron Microscope Test Probe with Energy Filter in the Lens," Serial No. 712,593, filed March 15, 1985 and a continuation-in-part of that application, "Improved Electron Beam Test Probe for Integrated Circuit Testing," Serial No. 766,905, filed August 16, 1985. In a preferred embodiment the electron beam is directed downward onto the wafer which has been automatically positioned using an automated handling system.

It should be appreciated that although a preferred embodiment of the invention has been described above, this embodiment is intended only to illustrate the invention. The scope of the invention may be determined from the appended claims.

## Claims

1. A method for testing a semiconductor structure having a semiconductor substrate and having a test pattern including a first region of conductive material electrically coupled to the substrate, and a second region of conductive material electrically isolated from the substrate, the method characterized by:

connecting the substrate to a first potential source;

directing a single beam of electrons onto the test pattern, the beam having an energy sufficient to cause the secondary emission coefficient of the conductive material to exceed unity and thereby produce a voltage contrast between the first and second regions; and

detecting the voltage contrast between the first and second regions to thereby test the semiconductor structure.

2. The method according to claim 1, characterized by fabricating at least one test pattern on said substrate by:

providing a layer of insulating material over a selected portion of the substrate;

depositing a layer of conductive material on the insulating material as well as in contact with the substrate; and

removing a portion of the layer of conductive material to thereby separate the layer into the first region and the second region.

3. The method according to claim 2, characterized in that the step of removing comprises removing a portion of the layer to provide a space between the first region and the second region having a minimum dimension.

4. The method according to claim 2 or 3, characterized by a step of forming other regions of material on the substrate prior to the step of providing a layer of insulating material.

5. The method according to any one of the previous claims, characterized in that the step of directing a beam is performed by placing the semiconductor structure in an electron microscope and the step of detecting comprises viewing the semiconductor structure with the electron microscope.

6. The method according to any one of the previous claims, characterized in that the step of directing a beam further comprises directing a beam of electrons of sufficiently low energy as not to effect operability of the semiconductor structure.

7. The method according to any one of the previous claims, characterized in that the step of fabricating comprises fabricating a plurality of the test patterns and the step of directing a beam further comprises scanning the beam across each of the plurality of test patterns.

8. A test pattern for verifying a minimum distance in a semiconductor structure, the pattern for use in apparatus for measuring voltage contrast characterized by:

a first region of conductive material disposed over the semiconductor structure and coupled to a potential source; and

a second region of conductive material electrically isolated from the potential source and disposed the minimum distance from the first region.

9. The structure according to claim 8, characterized by a layer of insulating material disposed between at least part of the first region and the semiconductor structure.

10. The structure according to claim 9, characterized in that the layer of insulating material is not planar to thereby provide at least one step for the first region to traverse.

11. The structure according to claim 9 or 10, characterized by a third region of conductive material disposed on the insulating material and spaced apart from the first and second regions to enable testing of the insulating material.

12. The structure according to any one of claims 8-11, characterized by a plurality of said test patterns disposed in an array.

FIG.—1.

$E_1 < E_L < E_2$

FIG.—2.

FIG.—3.

0237406

FIG._4.

FIG._5.

FIG._6a.

BAD CONTACT

BRIDGING PROBLEM

FIG._6b.